Europäisches Patentamt

European Patent Office

Office européen des brevets

(19)

(11) **EP 1 557 950 A1**

(12) **DEMANDE DE BREVET EUROPEEN**

(43) Date de publication:
**27.07.2005 Bulletin 2005/30**

(51) Int Cl.⁷: $H03K\ 23/68$, $H03K\ 23/66$

(21) Numéro de dépôt: **05100252.5**

(22) Date de dépôt: **17.01.2005**

(84) Etats contractants désignés:
**AT BE BG CH CY CZ DE DK EE ES FI FR GB GR HU IE IS IT LI LT LU MC NL PL PT RO SE SI SK TR**
Etats d'extension désignés:
**AL BA HR LV MK YU**

(30) Priorité: **20.01.2004 FR 0400495**

(71) Demandeur: **Thales**
**92200 Neuilly Sur Seine (FR)**

(72) Inventeurs:
• **De Gouy, Jean-Luc,**
  **THALES Intellectual Property**
  **94117 CX Arcueil (FR)**
• **Gabet, Pascal, THALES Intellectual Property**
  **94117 CX Arcueil (FR)**

(74) Mandataire: **Lucas, Laurent Jacques et al**
**THALES Intellectual Property,**
**31-33 avenue Aristide Briand**
**94117 Arcueil Cedex (FR)**

(54) **Procédé et dispositif de division de fréquence**

(57)    Dispositif et procédé de division de fréquence de rang de division N comportant au moins les éléments suivants :

• un diviseur d'entrée (10) de rang $N_{PS}$ recevant en entrée la fréquence $F_e$ et délivrant à un diviseur d'insertion/substitution (11) un signal $F_{PS}$,
• le diviseur d'insertion/substitution (11) comprenant une entrée $\Delta N$ de variation du rang de division N, délivrant une trame de commande C au diviseur d'entrée et générant un signal TC3 de fin de comptage,
• le diviseur d'insertion /substitution est adapté à insérer un ou plusieurs cycles de diviseur d'entrée et/ ou substituer un cycle de diviseur d'entrée dans la trame de commande C.

FIG.4

EP 1 557 950 A1

**Description**

L'invention concerne un dispositif de division de fréquence.

Elle s'applique, par exemple, dans le domaine de la synthèse de fréquence où le bruit de phase du diviseur constitue une performance clé.

Dans son principe général, un diviseur de fréquence de rang de division N permet de générer en sortie un signal de durée $N*T_e$ où $T_e$ est la période du signal d'entrée du diviseur. Ce signal de sortie de durée $N*T_e$ est généralement constitué d'un seul état haut et d'un seul état bas.

Lorsqu'un diviseur est placé dans une boucle à verrouillage de phase, la modification statique par pas de 1 du rang de division N, permet de générer des pas de fréquence en sortie de la boucle qui sont espacés de la valeur de la fréquence de comparaison de la boucle. Il est possible de générer des pas de fréquence qui sont une fraction de cette fréquence de comparaison, en utilisant le diviseur dans le mode fractionnaire. Dans ce mode, après avoir positionné statiquement le rang de division N, on fait évoluer dynamiquement ce rang au rythme de la fréquence de comparaison.

Il existe donc un intérêt à concevoir un diviseur ayant une capacité de variation dynamique de son rang de division. Cette variation dynamique se fait généralement sur quelques unités. Par exemple, le diviseur par N peut varier dynamiquement sur les 5 valeurs N, N+1, N+2, N+3 et N+4, c'est-à-dire $\Delta N$ pouvant prendre les valeurs de 0 à 4. On obtient ainsi, pour la boucle de phase, un rang de division apparent $N_{moyen}$ qui dépend de la séquence de variation de N. Par exemple, si on divise alternativement par N et N+1, le Nmoyen est égal à N+1/2.

Le fonctionnement du comparateur de phase de la boucle à verrouillage de phase impose des contraintes de facteur de forme pour le signal issu du diviseur.

Le signal de sortie du diviseur ayant un état haut et un état bas, on peut considérer les contraintes de facteur de forme suivantes: par exemple, dans le cas où, un des deux états (haut ou bas) du signal de sortie du diviseur a une durée constante indépendante de $\Delta N$,

- lorsque ($N_{moyen}$) est pair, cette durée constante est égale à $T_e*(N_{moyen})/2$ où $T_e$ est la période du signal d'entrée du diviseur,

- lorsque ($N_{moyen}$) est impair, cette durée est la valeur la plus proche de $T_e*(N_{moyen})/2$ où $T_e$ est la période du signal d'entrée du diviseur.

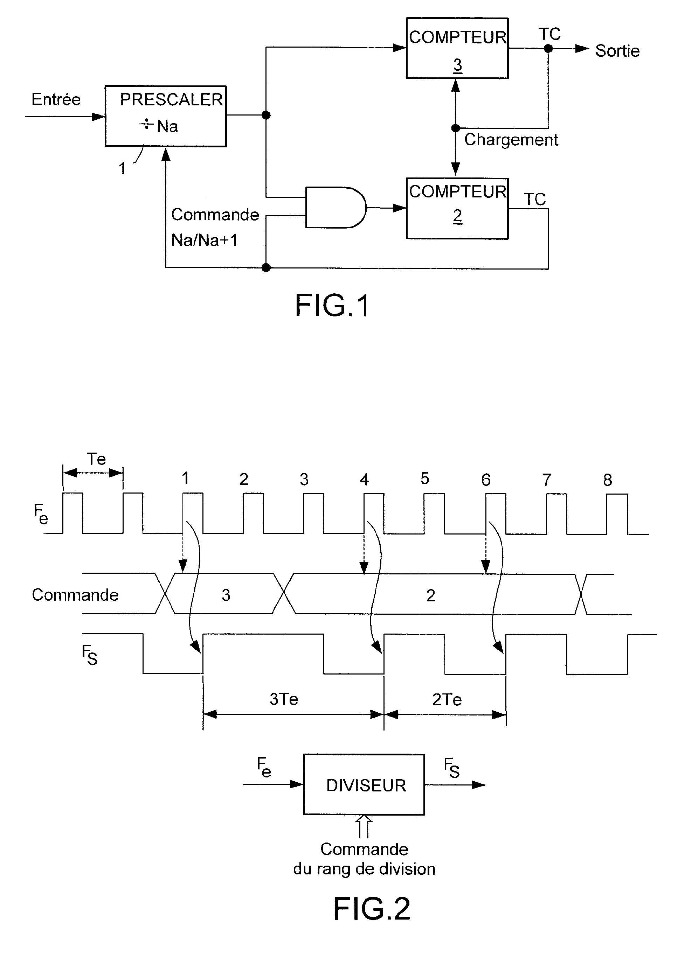

La figure 1 schématise la structure d'un diviseur de fréquence selon l'art antérieur. Il est composé d'un diviseur d'entrée ou prescaler 1 qui divise par Na ou par Na+1 la fréquence d'entrée $F_e$, d'un premier compteur 2 dont la sortie TC commande la division par Na ou Na +1 du prescaler, d'un deuxième compteur 3 dont la sortie TC est la sortie du dispositif. Une telle structure comporte notamment les inconvénients suivants :

- Les compteurs 2 et 3 sont des compteurs synchrones dont tous les étages doivent fonctionner à fréquence élevée égale à $F_e/Na$,
- L'implémentation des modes fractionnaires n'est pas aisée,
- Le nombre de couches logiques entre l'entrée et la sortie est généralement important ce qui limite les performances de bruit de phase.

L'invention concerne un dispositif et un procédé de division de fréquence permettant notamment de répondre au besoin de variation dynamique du rang de division N et de maîtrise des durées des états haut et bas du signal de sortie du diviseur.

La description fait appel à différentes définitions données ci-après.

Le terme « prescaler » est utilisé pour désigner un diviseur placé en tête d'une chaîne de division, qui présente en général une structure simple et qui fonctionne à vitesse élevée.

On définit aussi les expressions, variation dynamique ou variation statique du rang de division dans le contexte de la présente invention.

Pour un diviseur quelconque, deux modes de variation de son rang de division peuvent être envisagés.

1 - Dans le mode de variation dynamique, le passage d'un rang $N_1$ de division à un rang $N_2$ se fait sans perte de continuité dans le comptage des périodes du signal d'entrée $F_e$. La figure 2 représente un chronogramme montrant la commutation dynamique d'un diviseur. $F_e$ est la fréquence d'entrée du diviseur. Les flancs actifs de $F_e$ sont numérotés sur la figure. Les flancs 1, 4, 6 correspondent à un début de cycle du diviseur : sur ces flancs, le diviseur prend en compte la valeur de la commande qui va déterminer la durée du cycle de sortie. Un cycle de sortie est compté entre deux flancs montants du signal de sortie $F_s$. Le diagramme montre que les cycles de sortie s'enchaînent en parfaite continuité, sans laps de temps entre eux, ce qui caractérise la commutation dynamique de N.
2 - Lorsque les cycles de sortie du diviseur ne s'enchaînent pas en parfaite continuité lors des changements de rang de division, on parle alors de commutation statique : le diviseur demande un certain laps de temps pour changer son rang de division et les changements d'état qui se produisent pendant ce laps de temps ne sont pas toujours prédictibles.

Les mots trames et cycles désignent dans la description deux notions différentes explicitées ci-après.

Pour un diviseur à rang $N_1$ variable dynamiquement en réponse à la commande C, la division d'un signal d'entrée de fréquence $F_e$ donne le signal de sortie $F_{S1}$. Un cycle de comptage du diviseur a une durée égale à $N_1$ périodes de $F_e$ et est constitué d'un seul état haut et d'un seul état bas. La trame de comptage du diviseur désigne une suite de cycles $F_{S1}$, la durée $N_1 *T_e$ de chaque cycle est variable. La durée de cette trame dépend de la trame des commandes C. Si la trame des commandes C est composée de X valeurs, alors la trame de $F_{S1}$ comporte X cycles, chacun de durée commandée.

Il faut donc bien différencier entre la trame des commandes du diviseur et la trame de comptage : la trame de commande désigne la séquence des valeurs de division qui permet d'obtenir la durée souhaitée pour la trame de comptage.

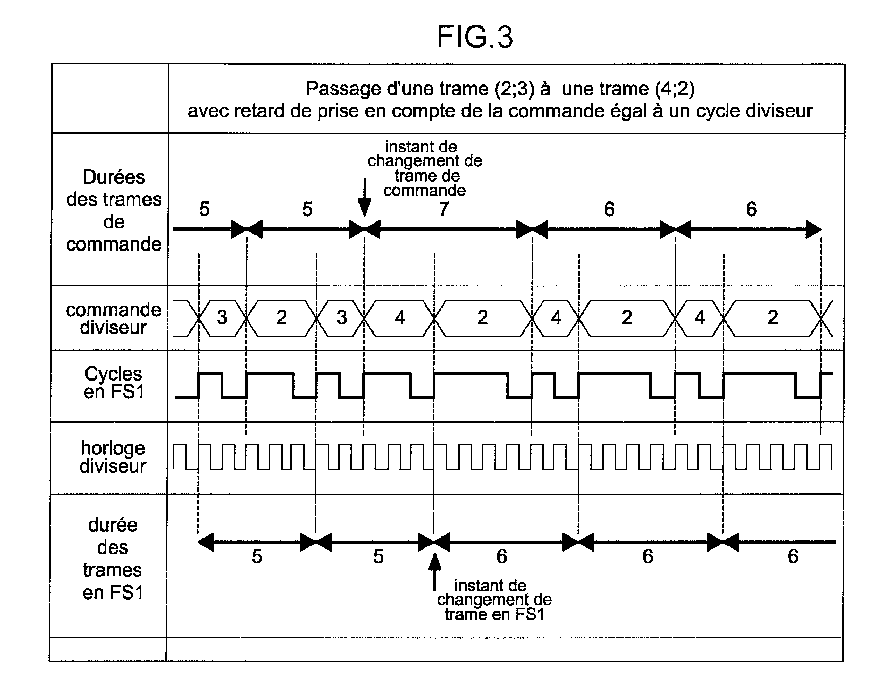

Comme cela est illustré par la figure 3, la durée de la trame des commandes peut être différente de la durée de la trame de comptage, si la commande est prise en compte avec un retard. Dans le chronogramme de la figure 3, la période des trames est constituée de deux valeurs, le passage d'une trame de commande [2 ; 3] à une trame de commande [4 ; 2] est représenté. On obtient une trame de comptage dont la durée passe de $5T_e$ à $6T_e$, mais ce n'est pas le cas de la trame des commandes qui passe de 5Te à 7Te puis à 6Te.

L'invention concerne un dispositif de division de fréquence de rang de division N caractérisé en ce qu'il comporte au moins les éléments suivants :

- un diviseur d'entrée de rang $N_{PS}$ recevant en entrée la fréquence $F_e$ et délivrant à un diviseur d'insertion/substitution un signal $F_{PS}$,
- le diviseur d'insertion/substitution comprenant une entrée $\Delta N$ de variation du rang de division N, délivrant une trame de commande C au diviseur d'entrée ( avec un rythme d'une valeur par cycle de $F_{PS}$) et générant un signal TC3 de fin de comptage,
- le diviseur d'insertion/substitution étant adapté à insérer un ou plusieurs cycles de diviseur d'entrée et/ou substituer un cycle de diviseur d'entrée dans la trame de commande C

Les valeurs du rang $N_{PS}$ du diviseur d'entrée varient, par exemple, sur un octave.

Le dispositif peut comporter un dispositif de décodage et un diviseur supplémentaire délivrant au diviseur d'insertion/substitution une séquence de données RX4 et un signal de fin de comptage TC4, le diviseur supplémentaire recevant des commandes statiques du dispositif de décodage.

Il peut comporter un dispositif de sortie synchrone recevant au moins la fréquence d'entrée $F_e$, le signal $F_{PS}$, le signal de fin de comptage TC3 issu du diviseur d'insertion substitution, un signal de contrôle des états hauts et bas de la sortie synchrone $F_{SY}$.

Le diviseur d'entrée comporte, par exemple, 3 bascules D et l'une des trois bascules commande, pendant une période de Fe par cycle de FPS, le chargement des 3 bascules.

Le diviseur d'entrée peut comporter trois bascules et la sortie d'au moins une des bascules est par exemple en liaison avec l'entrée d'une ou plusieurs des trois bascules via un multiplexeur uniquement.

L'invention concerne aussi un procédé pour diviser une fréquence $F_e$ caractérisé en ce qu'il comporte au moins une étape de division de la fréquence $F_e$ par un rang de division $N_{PS}$, la valeur de ce rang étant commandée par un bus de commande C modifié par substitution d'un cycle et/ou l'insertion d'un ou de plusieurs cycles dans la trame de comptage.

L'invention présente notamment les avantages suivants :

- Le dispositif est optimum en termes de bruit de phase, il ne présente par exemple qu'une seule bascule logique entre l'entrée $F_e$ et la sortie $F_{SY}$.
- La plage de programmation par l'utilisateur du rang de division N se trouve sur plusieurs octaves avec un rang minimum de quelques unités,
- N peut varier dynamiquement d'une valeur $\Delta N$ tout en contrôlant la durée d'un des deux états du signal de sortie. Ceci permet de répondre au besoin résultant de l'utilisation de ce diviseur dans des asservissements à verrouillage de phase ou PLL (abrégé anglo-saxon de Phase Locked Loop) à multiples pas fractionnaires, le terme multiple est associé au fait que la variation $\Delta N$ maximale est égale à plusieurs unités.

D'autres caractéristiques et avantages de la présente invention apparaîtront mieux à la lecture de la description d'un exemple de réalisation donné à titre illustratif et nullement limitatif annexé des figures qui représentent :

- La figure 1 un schéma synoptique d'un diviseur de fréquence selon l'art antérieur,
- La figure 2 un chronogramme montrant la commutation dynamique d'un diviseur,
- La figure 3 un exemple de passage d'une trame (2 ; 3) à une trame (4 ;2),
- La figure 4 un schéma synoptique d'un exemple de diviseur de fréquence selon l'invention,
- La figure 5 un exemple de schéma d'un diviseur d'entrée 2/3/4,
- Les figures 6A et 6B, un tableau et un chronogramme représentant les états hauts et bas du diviseur d'entrée de la figure 5,
- Les figures 7 et 8 deux exemples de réalisation de parties du diviseur d'entrée de la figure 5,
- La figure 9 un schéma synoptique d'un diviseur d'insertion/substitution,
- La figure 10 un tableau donnant les substitutions et insertions de cycles réalisés avec la configuration du diviseur d'entrée de la figure 5 suivi du diviseur d'insertion/substitution de la figure 9
- La figure 11 un exemple de chronogramme pour le diviseur d'insertion/substitution de la figure 9,
- La figure 12 un schéma d'un diviseur supplémentaire,
- La figure 13 un exemple de synoptique d'un bloc de sortie synchrone.

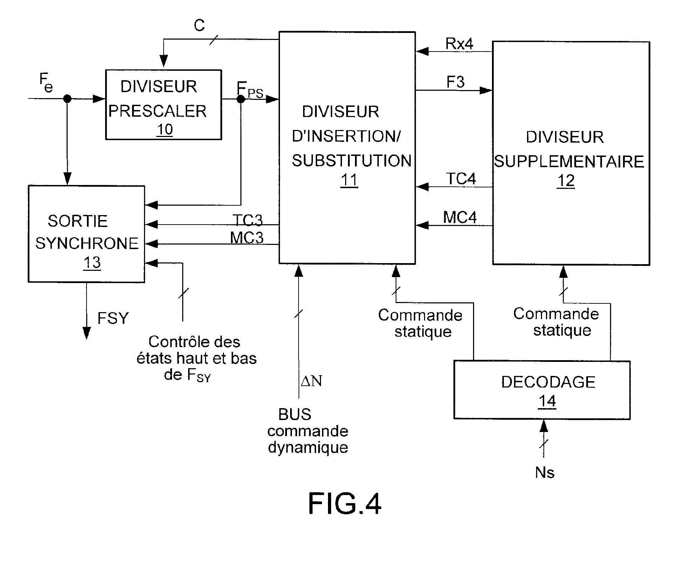

La figure 4 représente un exemple d'architecture d'un diviseur de fréquence selon l'invention composé par exemple de 5 blocs.

- Un bloc diviseur d'entrée placé en tête de la chaîne de division ou diviseur prescaler 10
- Un bloc diviseur d'insertion/substitution 11
- Un bloc diviseur supplémentaire 12
- Un bloc sortie synchrone 13
- Un bloc de décodage 14.

L'ensemble fonctionne de la manière décrite ci-après, les blocs et leur fonction étant eux-mêmes détaillés. Le rang de division N de l'ensemble ainsi formé est défini comme N=Ns+$\Delta$N où Ns est la partie statique de N et $\Delta$N la variation demandée.

Le signal d'entrée $F_e$ est divisé par le rang de division $N_{PS}$ du diviseur d'entrée 10 qui délivre le signal $F_{PS}$ au diviseur d'insertion/substitution 11. $N_{PS}$ peut prendre, par exemple, toutes les valeurs sur un octave de A à 2A, en réponse à un bus de commande C provenant du diviseur d'insertion/substitution 11.

Le diviseur d'insertion/substitution 11 possède par exemple P rangs de division consécutifs NI dont au moins les rangs 2 et 3 (P est donc supérieur ou égal à 2). Il a notamment pour fonction : d'une part d'élaborer la trame des commandes C du diviseur d'entrée à partir d'une séquence Rx4 provenant du diviseur supplémentaire 12, d'autre part de prendre en compte les demandes dynamiques de variation $\Delta$N (provenant d'un bus de commande, par exemple) en modifiant la trame de commande C du diviseur d'entrée par la substitution d'un cycle et/ou l'insertion de un ou plusieurs cycles supplémentaires dans la trame de comptage, par exemple (P-1) cycles supplémentaires de diviseur d'entrée, en faisant varier le rang de division NI du diviseur d'insertion/substitution. Chaque cycle inséré ou substitué comprend une ou plusieurs périodes de Fe. La séquence Rx4 est indépendante de $\Delta$N ce qui simplifie le dispositif en limitant le besoin de commutation dynamique aux seuls diviseurs d'insertion/substitution et d'entrée. Le diviseur d'insertion/substitution reçoit aussi les commandes de fin de comptage TC4 et de milieu de comptage MC4 du diviseur supplémentaire, des commandes (paramétrage du circuit), des donnés statiques et le bus de commande dynamique $\Delta$N dont les fonctions sont explicitées ci-après.

La sortie du diviseur d'insertion/substitution 11 est le signal $F_3$ (égal à $F_{PS}$/NI) qui est aussi l'entrée horloge du diviseur supplémentaire 12. Le diviseur d'insertion/substitution délivre aussi les signaux TC3 et MC3 décrits ci-après.

Le diviseur supplémentaire 12 reçoit le signal $F_3$ et répond à ce signal par le signal Rx4, possédant le même ou sensiblement le même rythme que $F_3$, une valeur par cycle de $F_3$, et qui est composé d'une séquence périodique de valeurs logiques. Ce diviseur supplémentaire 12 fournit également :

- Le signal TC4 qui rend compte de la fin de comptage du diviseur supplémentaire,
- Eventuellement, un signal MC4 qui rend compte du milieu de comptage du diviseur supplémentaire. Il offre notamment une possibilité supplémentaire en terme de contrôle des états logiques haut et bas du signal de sortie du bloc synchrone 13.

A partir de ces deux signaux, TC4 et MC4, le diviseur d'insertion/substitution génère respectivement les signaux TC3 et MC3 qui rendent compte respectivement de la fin et du milieu de comptage de l'ensemble des deux diviseurs : le diviseur d'insertion/substitution 11 et le diviseur supplémentaire 12.

Le bloc de sortie synchrone 13 a notamment pour fonction de re synchroniser sans ambiguïté les transitions du cycle de sortie (de la totalité du diviseur) par la fréquence d'entrée $F_e$ du diviseur tout en imposant, par exemple, de n'avoir qu'une seule bascule logique entre l'horloge $F_e$ et la sortie $F_{SY}$. Ceci permet de maximiser les performances de bruit de phase. Il a notamment pour entrées les signaux TC3, MC3, le bus de contrôle des états haut et bas de $F_{SY}$, la fréquence divisée $F_{PS}$ et la fréquence d'entrée $F_e$. Pour une fréquence d'entrée $F_e$ de 10 GHz et un rang N de 10 000, le terme « sans ambiguïté » correspond au fait que la position du signal de sortie de fréquence 1 MHz, est connue à mieux que 100 ps (pico secondes), avec éventuellement un offset indépendant de Ns (Ns correspond à la partie statique du rang de division ) et de $\Delta$N, par rapport au flanc de $F_e$ qui est à l'origine du début de la trame de comptage. Le signal de sortie du diviseur est composé d'un seul cycle, c'est-à-dire d'un seul état haut et d'un seul état bas. Le bloc de sortie synchrone 13 est, par exemple, configurable de façon à permettre deux modes :

- Dans un premier mode, le cycle de sortie correspond à une seule trame de comptage. Le début et la fin du cycle sont repérés par le signal TC3. MC3 permet de générer la transition intermédiaire (entre état haut et bas de $F_{SY}$). En ajustant le retard de MC3 par rapport à TC3, on ajuste le facteur de forme de $F_{SY}$.
- Dans un second mode, chaque état du cycle de sortie correspond à une ou plusieurs trames de comptage. Ainsi, on peut faire varier le facteur de forme en ajustant le nombre et la durée de chaque trame de comptage pour chacun des deux états de $F_{SY}$. Dans ce mode, seul le signal TC3 est utilisé. Ce mode permet également d'augmenter la gamme des rangs de division réalisables, ce qui constitue une extension de N.

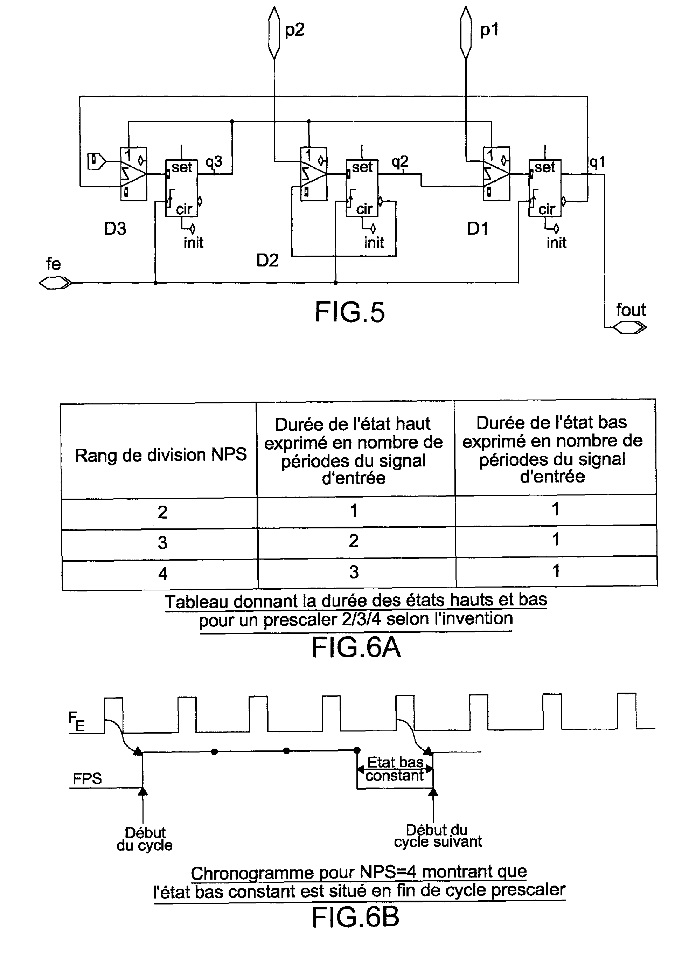

Les figures 5 à 13 représentent un exemple détaillé de l'architecture d'un dispositif selon l'invention et son fonctionnement, pour lequel le diviseur d'entrée 10 a pour fonction de diviser par les rangs 2, 3 et 4, le diviseur d'insertion/substitution 11 divise par 2 et 3 et le diviseur supplémentaire 12 possède une structure dite « entonnoir » par exemple telle que celle décrite ci-après ou dans la demande de brevet du demandeur FR 03/01485.

Diviseur d'entrée ou prescaler

Le diviseur d'entrée possède un bus de commande permettant de faire varier le rang de division $N_{PS}$ de façon dynamique, c'est-à-dire avec continuité dans le comptage. Ce rang de division a, par exemple, la capacité de variation sur un octave, c'est-à-dire qu'il peut prendre toutes les valeurs entre A et 2A. Pour A=2, le bus de commande possède 2 fils binaires et le rang $N_{PS}$ peut prendre les valeurs 2, 3 et 4.

Afin de générer une sortie synchrone, par un procédé de resynchronisation sans ambiguïté des transitions du signal de sortie, le signal $F_{PS}=F_e/N_{PS}$ est choisi de façon telle qu'il possède un état de durée constante, égale, par exemple, à une seule période du signal d'entrée $F_e$. Cet état constant ou sensiblement constant est par exemple situé en fin du cycle du diviseur d'entrée. En choisissant comme convention que le début du cycle diviseur d'entrée commence par un flanc montant, on doit donc avoir un état bas de durée égale à une période de $F_e$ qui sera située en fin du cycle.

La figure 5 schématise un exemple d'architecture pour le diviseur d'entrée ou prescaler 2/3/4, permettant notamment de répondre au besoin de facteur de forme évoqué ci-dessus.

Il comporte par exemple 3 bascules D, référencées, D1, D2, D3 dont les sorties sont notées Q1, Q2 et Q3. Q1 est la sortie du diviseur d'entrée. Les signaux d'entrée P1 et P2 permettent de commander le rang de division. Ce schéma est optimum en terme de fréquence de fonctionnement, car les chemins de rebouclage entre la sortie Qi d'au moins une des 3 bascules D et l'entrée d'une autre bascule Di, ne comporte, en fonctionnement normal, qu'un seul multiplexeur qui est généralement intégré ou intégrable à la bascule D dans la plupart des technologies.Toute bascule ayant une sortie qui mémorise la valeur de l'entrée à l'instant de la transition d'horloge (front d'horloge positif ou négatif) peut être utilisée.

Une autre caractéristique de cet étage d'entrée est que l'une des 3 bascules, Q3 dans cet exemple, commande pendant une unique période de $F_e$ par cycle de $F_{PS}$ , le chargement des 3 bascules.

Les relations logiques entre P1, P2 et les composantes C1, C2 du bus C de commande du diviseur d'entrée sont par exemple :

$$P1 = C1.or.C2$$

$$P2 = (C1.and.C2 ).or.(\overline{C1}.and.\overline{C2})$$

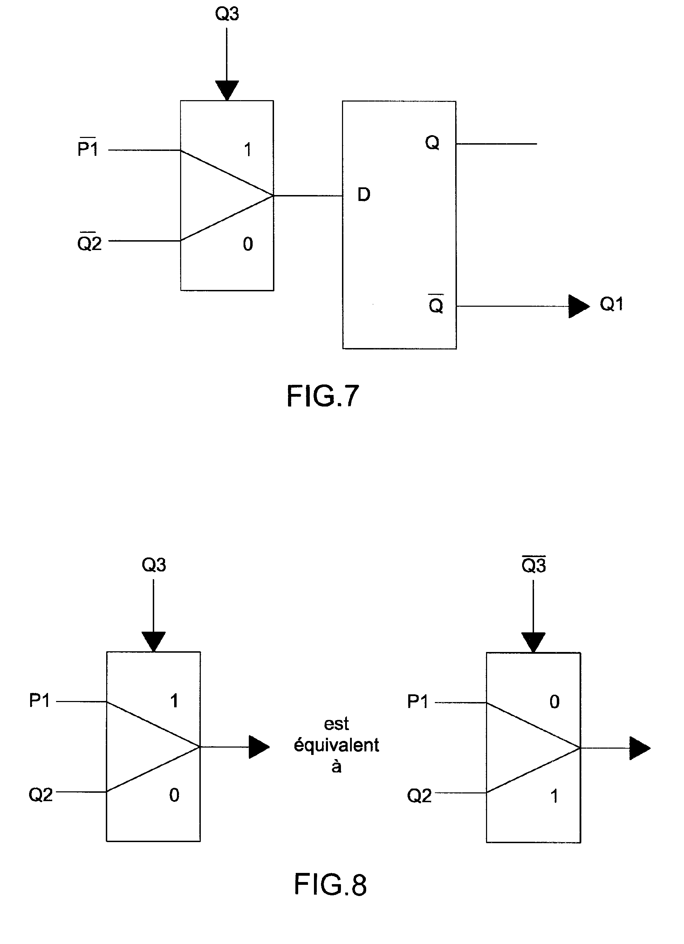

La figure 7 schématise une autre variante où une ou plusieurs parties du schéma de la figure 5 est obtenue en complémentant par exemple les entrées et les sorties des bascules. La figure 8 représente un mode de réalisation où le signal de commande est inversé sur un ou plusieurs multiplexeurs.

Le tableau 1 de la figure 6A donne la durée des états haut et bas pour chaque rang de division et la figure 6B un chronogramme montrant que l'état de durée constante est situé en fin de cycle de prescaler 2/3/4. Diviseur d'insertion/substitution

Ce diviseur reçoit la demande de la variation ΔN souhaitée par l'utilisateur. Le diviseur d'insertion/substitution élabore alors la trame C des commandes du diviseur d'entrée et permet la modification dynamique de cette trame. L'altération du rang de division N est effectuée par exemple de la façon suivante :

- Substituer dans la trame, un cycle de diviseur d'entrée (cycle de prescaler) par un autre cycle de durée différente, ou
- Insérer dans la trame, un ou plusieurs cycles de diviseur d'entrée supplémentaires (cycles de prescaler), ou
- Combiner les deux opérations précédentes, c'est-à-dire l'insertion d'un ou de plusieurs cycles supplémentaires et la substitution d'un cycle de diviseur d'entrée (cycle de prescaler).

Le choix entre ces trois possibilités est effectué, par exemple, en fonction de la valeur ΔN à réaliser et de la valeur de la commande C avant altération.

L'exemple suivant illustre une manière pour choisir l'altération du rang.

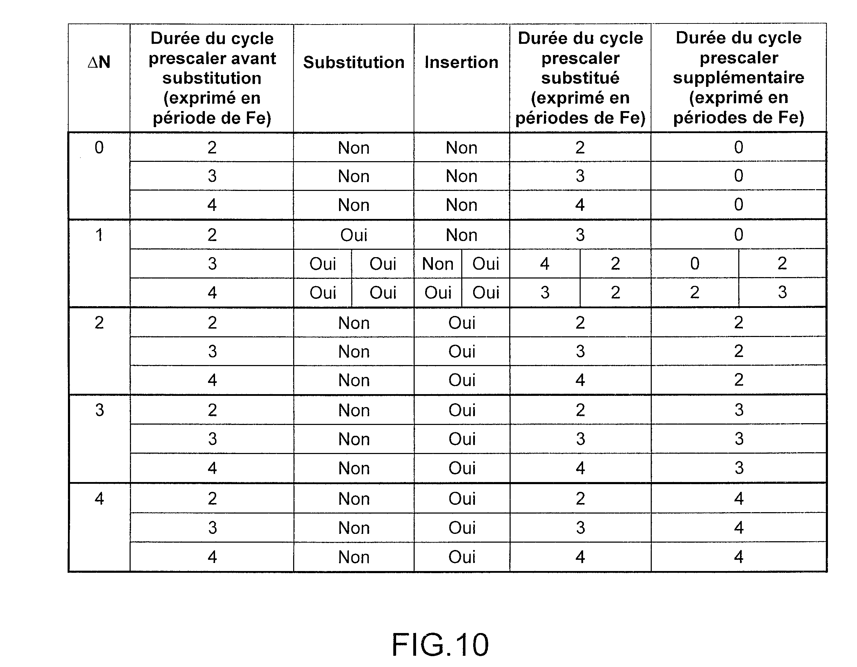

Pour un diviseur d'entrée réalisant les rangs 2/3/4 et un diviseur d'insertion/substitution réalisant les rangs 2 et 3, le tableau de la figure 10 donne, à titre illustratif et nullement limitatif, les durées des cycles de diviseur d'entrée (cycles de prescaler) avant et après le processus d'insertion/substitution de cycles.

Le procédé d'insertion/substitution est réalisé au moins une fois par trame de comptage du diviseur. Ce procédé est activé par le signal TC4 de fin de comptage du diviseur supplémentaire.

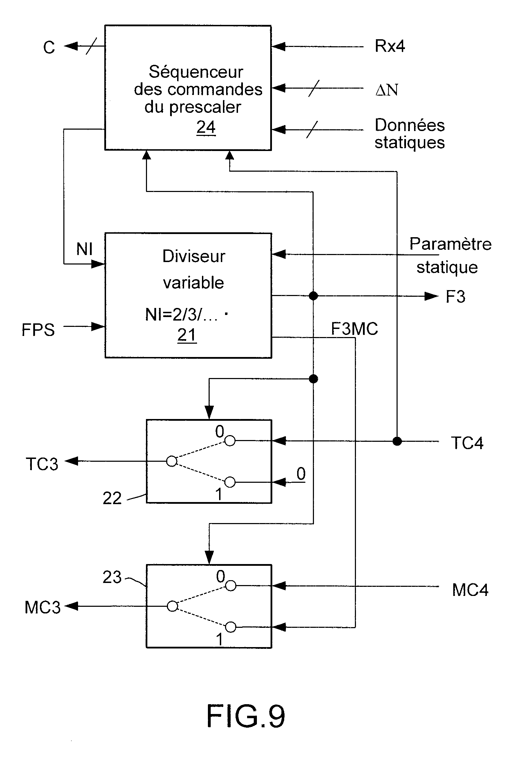

La figure 9 schématise un exemple de diviseur d'insertion/substitution comprenant :

- Un diviseur 21 variable de rang NI prenant au moins les valeurs 2 et 3. Ce diviseur reçoit le signal $F_{PS}$ et délivre le signal divisé $F_3$.
- Un moyen de découpe 22 qui reçoit le signal TC4 de fin de comptage du diviseur supplémentaire, lequel TC4 est découpé par $F_3$ pour donner le signal TC3 qui rend compte de la fin de comptage de l'ensemble « diviseur d'insertion/substitution et diviseur supplémentaire ».
- Un moyen de multiplexage 23 qui élabore le signal de milieu de comptage MC3 à partir du signal de milieu de comptage MC4 fourni par le diviseur supplémentaire et de F3MC fourni par le diviseur de rang NI. F3MC sert à initialiser le signal de milieu de comptage MC3 dans le cas particulier où le diviseur supplémentaire est inactif. Dans les autres cas F3MC est égal à zéro.
- Un séquenceur 24 des commandes du diviseur d'entrée qui reçoit le bus ΔN provenant de l'utilisateur, la séquence Rx4 provenant du diviseur supplémentaire et un bus de données statiques provenant du décodage de NS (partie statique du rang de division N).

  L'ensemble de ces trois données est par exemple séquencé par les signaux TC4 et F3 pour former le bus de commande C du diviseur d'entrée. Pour certaines valeurs de ΔN, le séquenceur 24 insère un ou plusieurs cycles de diviseur d'entrée supplémentaires : cela est mis, par exemple, en oeuvre par le séquenceur en faisant varier le rang de division NI. Cette variation est susceptible de se produire au moins une fois dans la trame de comptage de l'ensemble du diviseur.

L'un des avantages de cette structure est qu'elle s'interface naturellement avec un diviseur supplémentaire dont la structure est de type entonnoir.

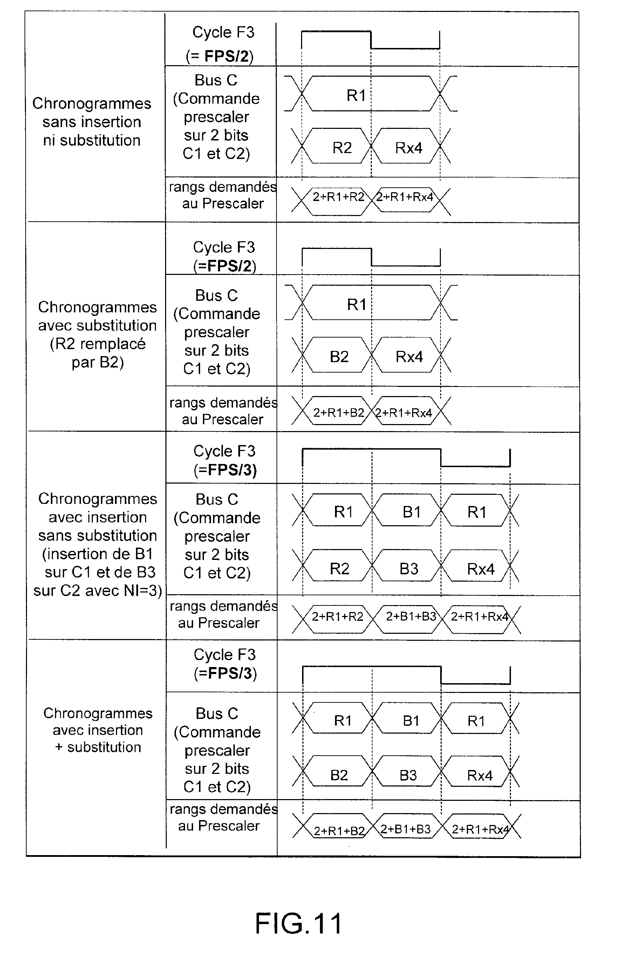

Le tableau de la figure 11, donne un exemple de chronogrammes décrivant le processus d'insertion et/ou de substitution de cycles prescaler. Il illustre le fonctionnement du séquenceur 24 de la figure précédente. Sur cet exemple, on a représenté les chronogrammes du bus C pendant le cycle de $F_3$ durant lequel on réalise l'insertion et/ou la substitution de cycles. Par exemple, un seul cycle de $F_3$ est modifié pendant toute la trame qui compte en général de nombreux cycles de $F_3$. Dans ce tableau, c'est pendant l'état haut de $F_3$ que le procédé est exécuté.

Pour ces chronogrammes, les valeurs $R_1$ et $R_2$ sont les données statiques du séquenceur situé dans le bloc diviseur « d'insertion/substitution » de la figure 9. Les valeurs $B_1$, $B_2$ et $B_3$ sont déduites du bus de commande dynamique ΔN. $C_1$ et $C_2$ sont les bits du bus C de commande du prescaler. Le rang de division $N_{PS}$ demandé au diviseur d'entrée est égal à $2+ C_1+ C_2$. Le signal de sortie $F_3$ possède un facteur de forme qui participe au processus de resynchronisation pour l'élaboration de la sortie synchrone. A cette fin, ce signal $F_3$ possède un état de durée constante situé, par exemple, en fin de cycle et dont la durée est égale à une seule période du signal d'entrée FPS.

Le tableau de la figure 10 donne les substitutions et insertions de cycles réalisés pour implémenter la variation ΔN dans le diviseur du schéma composé d'un étage d'entrée 2/3/4 suivi d'un diviseur 2 et 3.

Diviseur supplémentaire

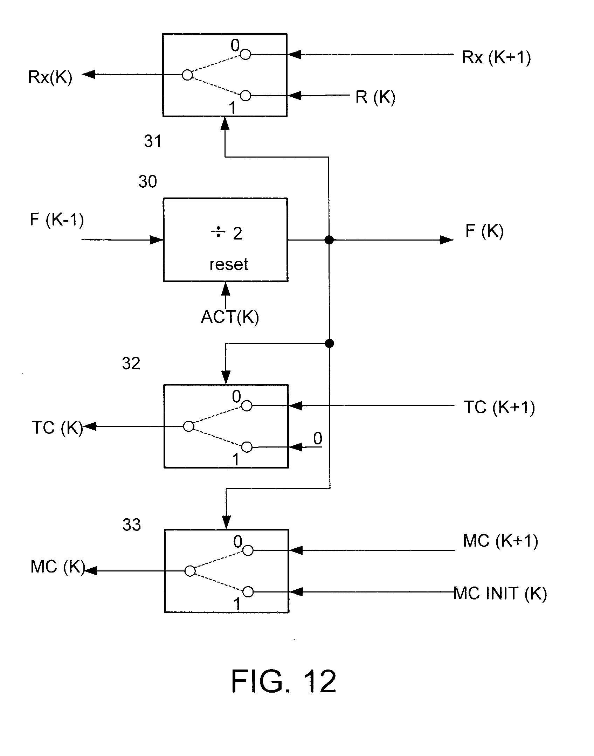

Le diviseur supplémentaire possède par exemple une structure de type entonnoir, telle que celle décrite à la figure 12. Sans sortir du cadre de l'invention, tout diviseur capable de fournir une séquence identique à la séquence Rx4 ainsi qu'un signal de fin de comptage peut être utilisé. La structure de type entonnoir est composée d'étages identiques asynchrones (au sens où l'horloge d'un étage est la sortie de l'étage précédent) disposés en cascade.

La figure 12 est un schéma synoptique d'un étage du diviseur-supplémentaire. Le numéro d'un étage est repéré par l'indice K, avec K=4 par exemple pour le premier étage du diviseur supplémentaire.

Chaque étage K est caractérisé par :

- Un diviseur par 2, référencé 30, dont l'entrée F(K - 1) provient de l'étage précédent K-1 et dont la sortie F(K) est fournie à l'étage suivant K+1 ;
- Un moyen de multiplexage 31, des signaux R(K) et Rx(K+1), qui fournit Rx(K), les Rx(K) participent à la formation de la séquence Rx4 ;
- Un moyen de découpe 32 pour le signal TC(K+1), signal qui rend compte de la fin de comptage des étages d'indice supérieurs ou égal à K+1 ;
- Un moyen de multiplexage 33 des signaux MC(K+1 ), MCINIT (K) qui fournit MC(K).

Différents signaux sont associés à un étage K, par exemple:

- Des signaux TC(K + 1), MC(K + 1) et Rx(K + 1) provenant de l'étage K+1 suivant.
- Des signaux TC(K), MC(K) et Rx(K) fournis à l'étage précédent K-1.

Où:

TC(K) rend compte de la fin de comptage des étages d'indice supérieur ou égal à K. MC(K) rend compte du milieu de comptage des étages d'indice supérieur ou égal à K. Rx(K) participe à la formation de la séquence Rx4.

- Des données et commandes statiques R(K), ACT(K) et MCINIT(K) qui permettent à l'utilisateur de configurer l'étage K en fonction du rang de division statique Ns à réaliser.

Où:

ACT(K) permet d'inhiber le fonctionnement de l'étage. L'ensemble des ACT(K) permettent donc de paramétrer le nombre d'étages actifs du diviseur supplémentaire, ce qui détermine la période de la séquence Rx4. Pour Y étages actifs, la séquence Rx4 possède $2^Y$ valeurs par période. Les valeurs Rx4 déterminent (avec les données statiques du diviseur d'insertion/substitution) les durées des cycles du diviseur d'entrée qui forment la trame de comptage, de façon à obtenir le rang Ns demandé. Lorsque tous les étages sont inactifs Rx4 est une valeur constante. MCINIT(K) permet d'initialiser la valeur de MC(K) dans le cas où l'étage suivant est inhibé.

Les différents étages d'indice K, K+1, .....de la structure entonnoir effectuent la sérialisation progressive des données statiques R(K) provenant des étages avals de la structure jusqu'à l'étage de tête de la structure entonnoir de façon à présenter une séquence de valeurs Rx4 synchrone avec l'horloge F3 (une valeur par cycle de F3).

On a les équations logiques suivantes :

$$Rx(K) = ( F(K).and.R(K) ).or.( \overline{F(K)} \, and.Rx(K + 1) )$$

$$TC(K) = \overline{F(K)}.and.TC(K + 1)$$

$$MC(K) = ( F(K).and.MCINIT(K) ).or.( \overline{F(K)}.and.MC(K + 1) )$$

Bloc de sortie synchrone

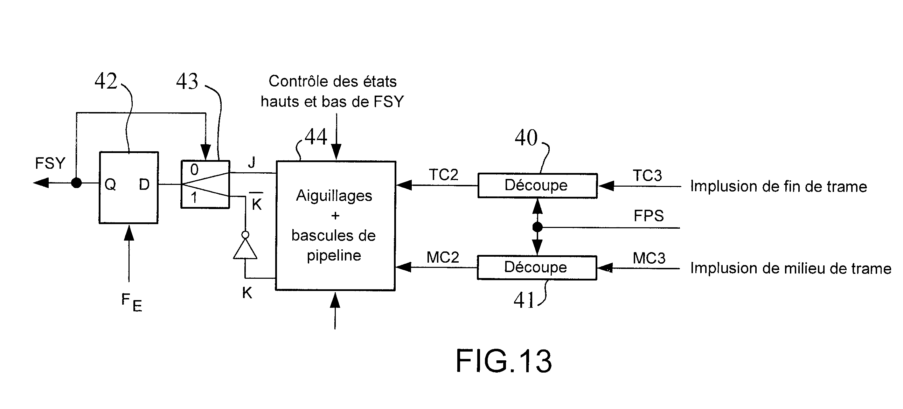

La figure 13 schématise un bloc de sortie synchrone.

Ce bloc a notamment pour fonction :

- De resynchroniser les transitions du cycle de sortie sur la fréquence d'entrée $F_e$ du diviseur. Cette resynchronisation est possible notamment grâce à la réalisation des fenêtres de validation robustes TC2 et MC2 qui sélectionne des flancs déterminés de $F_e$, par exemple, les flancs de $F_e$ qui déclenchent le début et le milieu de la trame; ces fenêtres sont réalisées à partir de TC3 et MC3. La robustesse est liée à la prolongation, dans ce bloc, du principe de la structure entonnoir qui consiste à redécouper les signaux TC, MC issus des étages avals par des fenêtres emboîtées de durée de plus en plus fine à mesure que l'on remonte vers l'amont.
- De contrôler les états haut et/ou bas de la sortie $F_{SY}$.

Le bloc de sortie synchrone comprend par exemple les éléments suivants :

- Un moyen 40 de découpe de TC3, impulsion de fin de trame en provenance du diviseur d'insertion/substitution, par l'état de durée constante de $F_{PS}$. De cette façon, le signal TC2 résultant de cette découpe a une durée égale à une période de $F_e$. Ce moyen comprend éventuellement un ou plusieurs étages de pipeline (étages de registres permettant de retarder le signal) cadencé avec l'horloge $F_{PS}$ afin d'aligner temporellement TC2 avec le début de la trame de comptage ;
- Un moyen 41 de découpe, de MC3 de structure identique ou sensiblement identique à 40 et fournissant en sortie MC2 dont la durée est égale à une période de $F_e$ ;
- Une bascule D, référencée 42, dont la sortie délivre $F_{SY}$. Elle comprend sur son entrée un multiplexeur 43 commandé par $F_{SY}$. Ce multiplexeur reçoit les signaux J et K qui sont délivrés par la fonction d'aiguillage délivrée par un ensemble 44;
- Un ensemble 44 comprenant des bascules de pipeline cadencé avec l'horloge $F_e$ et des aiguillages. Ainsi chacune des entrées J et K de la bascule de sortie est susceptible de recevoir les signaux suivants :

- TC2 ou des versions retardées de ce signal (grâce aux bascules de pipeline),
- MC2 ou des versions retardées de ce signal,
- des niveaux logiques constants.

Tout dispositif présentant une fonctionnalité semblable à celle d'une bascule J, K peut être utilisé à la place de la bascule D précitée. Le dispositif est optimum en termes de bruit de phase, il ne présente par exemple qu'une seule bascule logique entre l'entrée $F_e$ et la sortie $F_{SY}$.

Ces aiguillages peuvent être configurés différemment d'une trame à la suivante grâce à un bus appelé "contrôle des états hauts et bas de $F_{SY}$ ". Ceci permet une grande variété des modes de sortie. La fonction d'aiguillage est configurée par un bus modifiable à l'échelle de temps de la trame de façon à proposer à l'utilisateur différents modes pour la sortie synchrone $F_{SY}$ dont quelques exemples non exhaustifs seront données ci-après.

Le choix d'un mode se fait en fonction de l'application envisagée, comme on l'a vu par exemple dans le paragraphe donnant les besoins des PLL fractionnaires. Quelques exemples de modes possibles de réalisation sont donnés ci-après. Ces modes sont par exemple classés en deux catégories :

- Modes qui permettent d'ajuster les durées relatives des états hauts et bas pour les cas où le cycle de sortie correspond à une seule trame de comptage.
- Modes qui permettent de choisir la polarité constante 0 ou 1 pendant la trame modifiable de trame en trame, pour les cycles de sortie composés de plusieurs trames.

Dans la première catégorie de mode, le signal $F_{SY}$, constitué d'un état haut et d'un état bas, correspond à une seule trame de comptage. L'un des deux états n'est pas affecté par la variation $\Delta N$ : cet état ne dépend donc que du rang statique Ns. Pour réaliser ce mode, le signal TC2 est aiguillé vers J et le signal MC2 vers K. (remarque : d'après le principe de resynchronisation, on a resynchronisé aussi bien le flanc montant et le flanc descendant de $F_{SY}$)

De part la construction des signaux TC2 et MC2 à partir de TC3 et MC3, on obtient un facteur de forme proche de 50%( environ 50% de $Ns*T_e$ à l'état haut et 50% de $Ns*T_e$ à l'état bas, où $T_e$ est la période du signal d'entrée du diviseur).

Eventuellement, il est possible de retarder d'une ou plusieurs périodes de $F_e$ l'un des deux signaux TC2 ou MC2 (grâce aux bascules de pipeline de la fonction d'aiguillage) de façon à modifier le facteur de forme.

Dans la deuxième catégorie de mode, chaque état de $F_{SY}$ est composé de une ou plusieurs trames, et l'utilisateur programme pour chaque trame le $\Delta N$ et la polarité 0 ou 1.

Une trame de polarité 1 est obtenue en aiguillant TC2 vers J et en positionnant K à 0. Une trame de polarité 0 est obtenue en aiguillant TC2 vers K et en positionnant J à 1. Une période de $F_{SY}$, composée de plusieurs trames de polarité 1 suivies de plusieurs trames de polarité 0, permet d'obtenir un nouveau rang de division qui peut être beaucoup plus grand que le Nmaximun d'une seule trame du diviseur. Ce mode de sortie synchrone permet d'étendre (sans limitation) le rang de division ainsi que les capacités d'agilité (si la période de $F_{SY}$ est composée de X trames, on a une capacité de variation du rang de division égale à X*ΔN).

Dans l'application aux PLL fractionnaires, on cherche à obtenir un des deux états de $F_{SY}$ dont la durée est d'une part indépendante de ΔN et d'autre part voisine de 50% de $N_{moyen}*T_e$. Ceci est réalisable par la combinaison des deux modes évoqués ci-dessus.

**Revendications**

1.  Dispositif de division de fréquence de rang de division N **caractérisé en ce qu'**il comporte au moins les éléments suivants :

    - un diviseur d'entrée (10) de rang $N_{PS}$ recevant une fréquence $F_e$ et délivrant à un diviseur d'insertion/substitution (11) un signal $F_{PS}$,
    - le diviseur d'insertion/substitution (11) comprenant une entrée ΔN de variation du rang de division N, délivrant une trame de commande C au diviseur d'entrée et générant un signal TC3 de fin de comptage, et **en ce que** le diviseur d'insertion /substitution est adapté à insérer un ou plusieurs cycles de diviseur d'entrée et/ou substituer un cycle de diviseur d'entrée dans la trame de commande C.

2.  Dispositif selon la revendication 1 **caractérisé en ce que** les valeurs du rang NPS du diviseur d'entrée (10) varient sur un octave.

3.  Dispositif selon la revendication 1 **caractérisé en ce qu'**il comporte un dispositif de décodage (14) et un diviseur supplémentaire (12), délivrant au diviseur d'insertion/substitution une séquence de données R×4 et un signal de fin de comptage TC4, le diviseur supplémentaire recevant des commandes statiques du dispositif de décodage.

4.  Dispositif selon l'une des revendications 1 ou 3 **caractérisé en ce qu'**il comporte un dispositif de sortie synchrone (13) recevant au moins la fréquence d'entrée $F_e$, le signal $F_{PS}$, le signal de fin de comptage TC3 issu du diviseur d'insertion/substitution, un signal de contrôle des états hauts et bas de la sortie synchrone $F_{SY}$.

5.  Dispositif selon la revendication 1 **caractérisé en ce que** le diviseur d'entrée (10) comporte 3 bascules Di et **en ce que** l'une des trois bascules commande, pendant une période de $F_e$ par cycle de $F_{PS}$, le chargement des 3 bascules.

6.  Dispositif selon la revendication 1 **caractérisé en ce que** le diviseur d'entrée (10) comporte trois bascules D et **en ce que** la sortie d'au moins une des bascules D est en liaison avec l'entrée d'une ou plusieurs des trois bascules via un multiplexeur uniquement.

7.  Dispositif selon la revendication 1 **caractérisé en ce que** le diviseur d'insertion/Substitution (11) possède P rangs de division consécutifs avec P supérieur ou égal à 2.

8.  Dispositif selon l'une des revendications 1, 3 et 4 **caractérisé en ce que** le diviseur d'insertion/substitution (11) comporte au moins les éléments suivants :

    - Un diviseur variable (21) de rang NI prenant au moins les valeurs 2 et 3.
    - Un moyen de découpe (22) qui reçoit le signal TC4 de fin de comptage, lequel TC4 est découpé par le signal F3 issu du diviseur d'insertion/substitution afin de produire un signal TC3 de fin comptage,
    - Un séquenceur (24) des commandes du diviseur d'entrée qui reçoit le bus ΔN provenant de l'utilisateur, la séquence Rx4 et un bus de données statiques provenant du décodage de NS (partie statique du rang de division N).

9.  Dispositif selon la revendication 8 **caractérisé en ce qu'**il comporte un moyen de multiplexage (23) adapté à élaborer un signal de milieu de comptage MC3 à partir d'un signal de milieu de comptage MC4 et/ou à partir d'un signal d'initialisation F3MC fourni par le diviseur de rang NI.,

10. Dispositif selon la revendication 3 **caractérisé en ce que** le diviseur supplémentaire de rang K comporte au moins un diviseur (30), dont l'entrée F(K - 1) provient de l'étage précédent K-1 et dont la sortie F(K) est fournie à l'étage suivant K+1, un moyen de multiplexage (31) adapté à élaborer une séquence Rx(K) et un moyen de découpe (32) adapté à élaborer un signal de fin de comptage TC(K).

**11.** Dispositif selon la revendication 10 **caractérisé en ce qu'**il comporte un dispositif de multiplexage (33) adapté à l'élaboration d'un signal de milieu de comptage.

**12.** Dispositif selon la revendication 4 **caractérisé en ce que** le bloc synchrone (13) comporte au moins les éléments suivants :

- Un moyen de découpe (40) de la commande de fin de comptage TC3 et fournissant en sortie TC2 dont la durée est égale à une période de $F_e$.
- Une bascule (42) de sortie délivrant la sortie $F_{SY}$, comprenant sur son entrée un multiplexeur (43) commandé par $F_{SY}$,

**13.** Dispositif selon la revendication 12 **caractérisé en ce qu'**il comporte un ensemble (44) comprenant des bascules de pipeline cadencé avec l'horloge $F_e$ et des aiguillages.

**14.** Dispositif selon la revendication 12 **caractérisé en ce qu'**il comporte un moyen de découpe (41), du signal de milieu de comptage MC3 et fournissant en sortie MC2 dont la durée est égale à une période de $F_e$.

**15.** Procédé pour diviser une fréquence $F_e$ **caractérisé en ce qu'**il comporte au moins une étape de division de la fréquence $F_e$ par un rang de division $N_{PS}$, la valeur de ce rang étant commandée par un bus de commande C modifié par substitution d'un cycle et/ou l'insertion d'un ou de plusieurs cycles dans la trame de comptage.

**16.** Procédé selon la revendication 15 **caractérisé en ce que** le cycle substitué ou le ou les cycles insérés ont une durée égale ou sensiblement égale à une ou plusieurs périodes de la fréquence d'entrée $F_e$.

**17.** Procédé selon la revendication 15 **caractérisé en ce qu'**il comporte une étape de synchronisation de la sortie $F_{SY}$ sur la fréquence d'entrée $F_e$ et une étape de contrôle des états logiques de la sortie $F_{SY}$.

FIG.1

FIG.2

# FIG.3

| | Passage d'une trame (2;3) à une trame (4;2) avec retard de prise en compte de la commande égal à un cycle diviseur |
|---|---|
| Durées des trames de commande | 5    5    7    6    6 |
| commande diviseur | 3  2  3  4  2  4  2  4  2 |
| Cycles en FS1 | |
| horloge diviseur | |
| durée des trames en FS1 | 5    5    6    6    6 |

instant de changement de trame de commande

instant de changement de trame en FS1

EP 1 557 950 A1

FIG.4

FIG.5

| Rang de division NPS | Durée de l'état haut exprimé en nombre de périodes du signal d'entrée | Durée de l'état bas exprimé en nombre de périodes du signal d'entrée |
|---|---|---|
| 2 | 1 | 1 |
| 3 | 2 | 1 |
| 4 | 3 | 1 |

Tableau donnant la durée des états hauts et bas
pour un prescaler 2/3/4 selon l'invention

FIG.6A

Chronogramme pour NPS=4 montrant que
l'état bas constant est situé en fin de cycle prescaler

FIG.6B

FIG.7

est
équivalent
à

FIG.8

FIG.9

| $\Delta N$ | Durée du cycle prescaler avant substitution (exprimé en période de Fe) | Substitution | | Insertion | | Durée du cycle prescaler substitué (exprimé en périodes de Fe) | | Durée du cycle prescaler supplémentaire (exprimé en périodes de Fe) | |
|---|---|---|---|---|---|---|---|---|---|
| 0 | 2 | Non | | Non | | 2 | | 0 | |
| | 3 | Non | | Non | | 3 | | 0 | |
| | 4 | Non | | Non | | 4 | | 0 | |
| 1 | 2 | Oui | | Non | | 3 | | 0 | |
| | 3 | Oui | Oui | Non | Oui | 4 | 2 | 0 | 2 |
| | 4 | Oui | Oui | Oui | Oui | 3 | 2 | 2 | 3 |
| 2 | 2 | Non | | Oui | | 2 | | 2 | |
| | 3 | Non | | Oui | | 3 | | 2 | |
| | 4 | Non | | Oui | | 4 | | 2 | |
| 3 | 2 | Non | | Oui | | 2 | | 3 | |
| | 3 | Non | | Oui | | 3 | | 3 | |
| | 4 | Non | | Oui | | 4 | | 3 | |
| 4 | 2 | Non | | Oui | | 2 | | 4 | |
| | 3 | Non | | Oui | | 3 | | 4 | |
| | 4 | Non | | Oui | | 4 | | 4 | |

## FIG.10

EP 1 557 950 A1

| | | |
|---|---|---|
| Chronogrammes sans insertion ni substitution | Cycle F3 (= **FPS/2**) | |
| | Bus C (Commande prescaler sur 2 bits C1 et C2) | R1 <br> R2 \| Rx4 |
| | rangs demandés au Prescaler | 2+R1+R2 \| 2+R1+Rx4 |
| Chronogrammes avec substitution (R2 remplacé par B2) | Cycle F3 (=**FPS/2**) | |
| | Bus C (Commande prescaler sur 2 bits C1 et C2) | R1 <br> B2 \| Rx4 |
| | rangs demandés au Prescaler | 2+R1+B2 \| 2+R1+Rx4 |
| Chronogrammes avec insertion sans substitution (insertion de B1 sur C1 et de B3 sur C2 avec NI=3) | Cycle F3 (=**FPS/3**) | |
| | Bus C (Commande prescaler sur 2 bits C1 et C2) | R1 \| B1 \| R1 <br> R2 \| B3 \| Rx4 |
| | rangs demandés au Prescaler | 2+R1+R2 \| 2+B1+B3 \| 2+R1+Rx4 |
| Chronogrammes avec insertion + substitution | Cycle F3 (=**FPS/3**) | |
| | Bus C (Commande prescaler sur 2 bits C1 et C2) | R1 \| B1 \| R1 <br> B2 \| B3 \| Rx4 |
| | rangs demandés au Prescaler | 2+R1+B2 \| 2+B1+B3 \| 2+R1+Rx4 |

FIG.11

FIG. 12

FIG.13

**Office européen des brevets**

**RAPPORT DE RECHERCHE EUROPEENNE**

Numéro de la demande

EP 05 10 0252

## DOCUMENTS CONSIDERES COMME PERTINENTS

| Catégorie | Citation du document avec indication, en cas de besoin, des parties pertinentes | Revendication concernée | CLASSEMENT DE LA DEMANDE (Int.Cl.7) |
|---|---|---|---|
| X | GB 2 011 684 A (SIEMENS AG) 11 juillet 1979 (1979-07-11) * page 6, ligne 23 - page 8, ligne 8; figures 7-9 * | 1,2,5-7, 15-17 | H03K23/68 H03K23/66 |
| X | EP 0 474 616 A (ERICSSON GE MOBILE COMMUNICAT) 11 mars 1992 (1992-03-11) * colonne 5, ligne 32 - colonne 6, ligne 44; figure 3 * | 1,2, 15-17 | |
| A | US 4 357 527 A (KOJIMA TADASHI) 2 novembre 1982 (1982-11-02) * le document en entier * | 1,15 | |
| A | US 6 614 870 B1 (MILLER BRIAN M) 2 septembre 2003 (2003-09-02) * figures 4-6 * | 1,15 | |
| A | US 2002/186808 A1 (KOUZNETSOV KONSTANTIN ET AL) 12 décembre 2002 (2002-12-12) * le document en entier * | 1,15 | |

**DOMAINES TECHNIQUES RECHERCHES (Int.Cl.7)**

H03K

Le présent rapport a été établi pour toutes les revendications

| Lieu de la recherche | Date d'achèvement de la recherche | Examinateur |
|---|---|---|
| Munich | 13 mai 2005 | Santos, P |

CATEGORIE DES DOCUMENTS CITES

X : particulièrement pertinent à lui seul
Y : particulièrement pertinent en combinaison avec un autre document de la même catégorie
A : arrière-plan technologique
O : divulgation non-écrite
P : document intercalaire

T : théorie ou principe à la base de l'invention
E : document de brevet antérieur, mais publié à la date de dépôt ou après cette date
D : cité dans la demande
L : cité pour d'autres raisons
& : membre de la même famille, document correspondant

**ANNEXE AU RAPPORT DE RECHERCHE EUROPEENNE
RELATIF A LA DEMANDE DE BREVET EUROPEEN NO.**

EP 05 10 0252

La présente annexe indique les membres de la famille de brevets relatifs aux documents brevets cités dans le rapport de recherche européenne visé ci-dessus.
Lesdits members sont contenus au fichier informatique de l'Office européen des brevets à la date du
Les renseignements fournis sont donnés à titre indicatif et n'engagent pas la responsabilité de l'Office européen des brevets.

13-05-2005

| Document brevet cité au rapport de recherche | | Date de publication | Membre(s) de la famille de brevet(s) | | Date de publication |
|---|---|---|---|---|---|
| GB 2011684 | A | 11-07-1979 | DE | 2753398 B1 | 10-05-1979 |
| | | | DE | 2753453 B1 | 26-04-1979 |
| | | | AU | 511637 B2 | 28-08-1980 |
| | | | AU | 4205278 A | 28-06-1979 |
| | | | BE | 872432 A1 | 30-05-1979 |
| | | | BR | 7807823 A | 26-06-1979 |
| | | | CH | 641609 A5 | 29-02-1984 |
| | | | DK | 534478 A | 31-05-1979 |
| | | | FR | 2410916 A1 | 29-06-1979 |
| | | | IT | 1101130 B | 28-09-1985 |
| | | | JP | 54086258 A | 09-07-1979 |
| | | | LU | 80587 A1 | 05-06-1980 |
| | | | NL | 7811728 A | 01-06-1979 |
| | | | NO | 783984 A ,B, | 31-05-1979 |
| | | | SE | 7812310 A | 31-05-1979 |
| | | | YU | 278678 A1 | 30-06-1982 |
| | | | AT | 376337 B | 12-11-1984 |
| | | | AT | 844778 A | 15-03-1984 |
| EP 0474616 | A | 11-03-1992 | US | 5066927 A | 19-11-1991 |
| | | | AU | 638602 B2 | 01-07-1993 |
| | | | AU | 8369791 A | 12-03-1992 |
| | | | CA | 2050676 A1 | 07-03-1992 |
| | | | DE | 69128013 D1 | 27-11-1997 |
| | | | DE | 69128013 T2 | 19-02-1998 |
| | | | EP | 0474616 A2 | 11-03-1992 |
| | | | ES | 2109939 T3 | 01-02-1998 |
| | | | FI | 914166 A | 07-03-1992 |
| | | | HK | 1004075 A1 | 13-11-1998 |
| | | | JP | 2978296 B2 | 15-11-1999 |
| | | | JP | 5183428 A | 23-07-1993 |
| | | | MX | 9100958 A1 | 04-05-1992 |
| | | | NZ | 239629 A | 27-01-1995 |
| US 4357527 | A | 02-11-1982 | JP | 54102957 A | 13-08-1979 |
| | | | JP | 54102958 A | 13-08-1979 |
| | | | JP | 54102959 A | 13-08-1979 |
| | | | DE | 2903700 A1 | 02-08-1979 |
| | | | GB | 2016764 A ,B | 26-09-1979 |
| US 6614870 | B1 | 02-09-2003 | DE | 10325019 A1 | 26-02-2004 |
| US 2002186808 | A1 | 12-12-2002 | AUCUN | | |

EPO FORM P0460

Pour tout renseignement concernant cette annexe : voir Journal Officiel de l'Office européen des brevets, No.12/82